# EUROPEAN PATENT APPLICATION

(11) **EP 4 704 270 A1**
(43) Date of publication of application: **04.03.2026**
(21) Application number: 24197257.9
(22) Date of filing: 29.08.2024
(51) Int. Cl.: H01S 5/40, H01S 5/024, H01S 5/02315, H01S 5/02208, H01S 5/02257, H01S 5/0222

(54) **LASER DIODE HEADER WITH THERMOELECTRIC CONTROLLER**

(71) Applicant: SCHOTT AG, 55122 Mainz (DE); SCHOTT Singapore Pte. Ltd., 738959 Singapore (SG)
(72) Inventor: LI, Ong Wai, 738959 Singapore (SG); HETTLER, Robert, 84028 Landshut (DE); AOWUDOMSUK, Artit, 10210 Bangkok (TH); DRÖGEMÜLLER, Karsten, 82223 Eichenau (DE)
(74) Representative: Schott Corporate IP

(57) **Abstract**

A header (1) for an optoelectronic package, the header (1) comprising an electrically conducting eyelet (2) and at least one electrical feedthrough (22) in at least one opening (20) extending through the eyelet (2), the eyelet (2) comprising at least one cavity (5) opening to a first side (11) forming a mounting side for accommodating a thermoelectric cooler (7) with a laser diode (3) mounted thereon, so that in operation the laser diode (3) is cooled by the thermoelectric cooler (7), the cavity (5) being closed at a second side (12) opposite to the first side (11) so that a bottom (50) of the cavity (5) is formed, wherein the wall thickness (55) measured from the bottom (50) to the second side (12) opposite to the first side (11) is lower than the thickness of the eyelet (2).

## Description

The invention relates to data transmission devices, in particular to electro-optical transmitters. Specifically, the invention concerns a header for an optoelectronic package with a laser diode.

### Prior art

In the field of data transmission, a constant increase in transmission rates is requisite. The highest transmission rates can be achieved with optical data transmission. Currently, optical transmission links with 50 Gbit/s transmission rate are developed. The temperature of the laser diode needs to be controlled to stabilize the laser wavelength. For this purpose, thermoelectric coolers integrated into the laser diode package can be used. However, a thermoelectric cooler is comparably bulky and thereby increases the size of the package. The laser temperature is usually controlled because the maximum achievable laser modulation is slower for direct modulation, the O/E efficiency is lower, and the wavelength will be longer when is the laser becomes too hot. The operating temperature should be either within the commercial temperature (0 to 70°C) or industrial temperature (-40 to 85°C) range. So, at high temperature operation, the laser temperature should be cooled to guarantee the speed and feasible link distance (Ex 10km, 40km) which directly relates to optical power (fiber attenuation property) and wavelength of laser (fiber chromatic dispersion property, the longer the wavelength, the worse dispersion becomes).

US 2023/0344193 A1 discloses a stem for a semiconductor package with an eyelet including a flat plate having a first surface and a second surface opposite to the first surface, a cavity opening to the first surface of the flat plate, and a metal block protruding from the second surface of the flat plate, and a lead extending through the flat plate from the first surface to the second surface, wherein a volume of the metal block is substantially the same as a volume of the cavity. The cavity accommodates a cooling element. This arrangement allows to shorten the feedthrough pins, thereby reducing an impedance mismatch.

However, not only the pins of the feedthrough, but surprisingly also the thermoelectric cooler itself can increase radiation losses, although the cooler typically has a certain distance to the electrical supply lines. It is therefore an object of the invention to improve the high frequency characteristics of a cooled laser transmitter. The invention also aims to achieve a more compact design for such a component. These objectives are solved by the subject matter of the independent claims.

### Disclosure of the invention

The invention concerns a header for an optoelectronic package, the header comprising an electrically conducting eyelet and at least one electrical feedthrough in at least one opening extending through the eyelet. The eyelet comprises at least one cavity or recess which opens to a first side which forms a mounting side for accommodating a thermoelectric cooler with a laser diode mounted thereon, so that in operation the laser diode can be cooled by the thermoelectric cooler. The cavity is closed at a second side opposite to the first side so that a bottom of the cavity is formed. The header is dimensioned so that the wall thickness measured from the bottom to the second side opposite to the first side is lower than the thickness of the eyelet.

In a preferred embodiment, the cavity is a through hole through the eyelet, wherein a closing element is attached to the eyelet and closes the cavity at the second side. Accordingly, in this embodiment, the wall thickness measured from the bottom of the cavity to the second side corresponds to the thickness of the closing element.

According to this design, the thermoelectric cooler is at least partly recessed below the surface level of the first or mounting side. This has the surprising effect of reducing the coupling of electromagnetic signals into the thermoelectric cooler by shielding, which in turn reduces radiation losses in the electrical supply lines to the laser diode.

Preferred embodiments of the invention are shown in the figures and will be explained in more detail in the following description, wherein identical reference signs refer to identical or similar components or elements.

### Brief description of the figures:

Fig. 1 shows a laser diode header with thermoelectric cooler mounted on top of an eyelet.
Fig. 2 shows a cross section of a header with a cavity for accommodating a thermoelectric cooler.
Fig. 3 shows the header of Fig. 2 with mounted thermoelectric cooler and laser diode.
Fig. 4 shows a variant of the headers of Figs. 2, 3 with a plug like closing element.
Fig. 5 shows an optoelectronic package with a laser diode header.
Fig. 6 shows a further example of a header in perspective view.
Fig. 7 shows a cross section of the header of Fig. 6.
Fig. 8 shows a perspective view of a variant of the header shown in Fig. 6.
Fig. 9 shows a cross section of the header of Fig. 8.
Figs. 10 and 11 show variants of Fig. 9.
Figs. 12 to 14 show headers for multiple laser diodes.
Fig. 15 shows the frequency dependence of the optoelectric response for a header with thermoelectric cooler on top of the eyelet.
Fig. 16 shows the frequency dependence of the optoelectric response for a header with thermoelectric cooler buried in a cavity in the eyelet.
Fig. 17 shows a comparison of the optoelectronic response of two headers as shown in Fig. 1, with one of the headers having a shielding wall surrounding the thermoelectric cooler.
Fig. 18 shows a side view of a header with thermoelectric cooler mounted on top with indicated areas of high field strength.
Fig. 19 shows an electro-optical converter.

### Detailed description

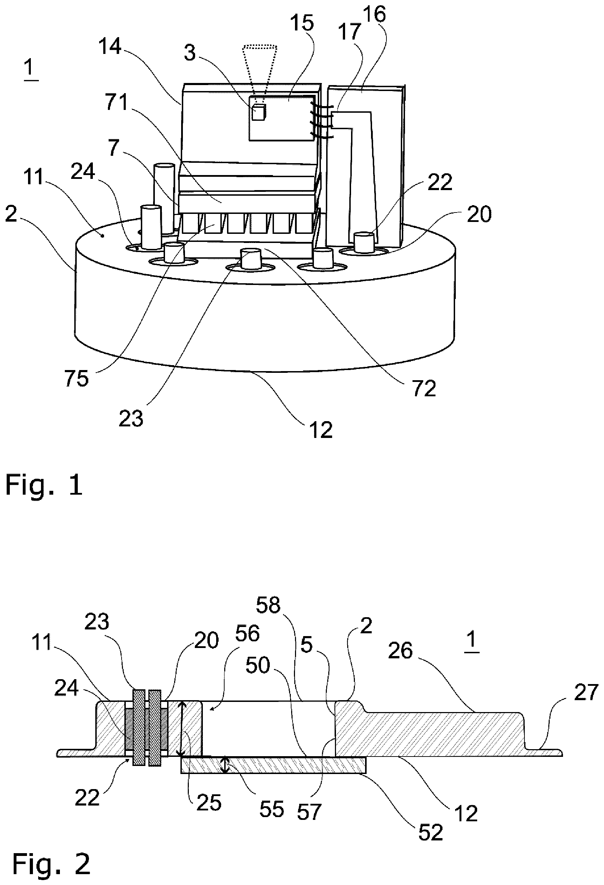

Fig. 1 shows a header 1 according to the prior art for an optoelectronic package with a laser diode 3 for optical data transmission. The header 1 comprises an eyelet 2 with openings 20 in which electrical feedthroughs for power and signal feeding are arranged. The feedthroughs 22 comprise one or more pins 23 held inside the opening 20 by an insulating material 24, preferably glass to provide a hermetic seal. A first side 11 of the eyelet 2 forms a mounting side, where the active components including the laser diode 3 are mounted. This side 11 also forms an inside face of the optoelectronic package. The opposite second side 12 forms an outside of the package, which, e.g. is mounted on a printed circuit board. To provide temperature control, the laser diode 3 is cooled with a thermoelectric cooler 7. In this embodiment, the thermoelectric cooler 7 is fixed onto the first side 11 with its hot plate 72. On the cold plate, a pedestal 14 is attached. On the pedestal 14 a submount 15 with the laser diode 3 is fixed. In this embodiment, the electrical signals for modulating the laser diode are fed to the laser diode 3 via one or more conductor traces 17 on a further submount 16. However, at very high modulating speeds, some coupling of the one or more conductor traces to the cavity like structure of the thermoelectric cooler 7 occurs which results in considerable signal strength losses. In addition, since the thermoelectric cooler 7 is mounted on top of the first side, the height of the thermoelectric cooler 7 adds up to the full dimensions of the optoelectronic package.

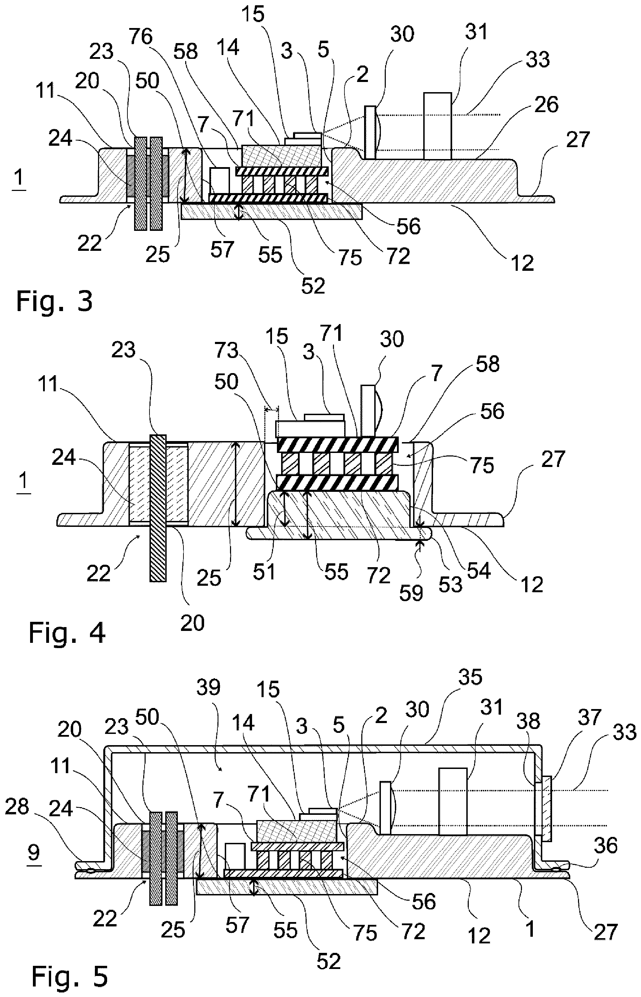

Fig. 2 shows a cross section of a header according to this disclosure, having a cavity for accommodating a thermoelectric cooler. Similarly to the comparative example of Fig. 1, the header 1 comprises a plate shaped eyelet 2 forming a base for mounting the active parts including a thermoelectric cooler and a laser diode. In difference to the comparative example of Fig. 1, the header 1 comprises a cavity 5. As explained further below; to produce an optoelectronic package for an optoelectronic converter, a thermoelectric cooler is inserted into the cavity 5 and fixed therein. For this purpose, the cavity 5 opens to the first side 11 which forms the mounting side. Further, the cavity 5 is closed at the opposite second side 12 so that the cavity 5 has a bottom 50. In particular, the wall thickness 55 at the cavity, measured from the bottom 50 to the second side 12 is lower than the thickness 25 of the eyelet 2. The eyelet 2 may have a non-uniform thickness. For example, the eyelet 2 of Fig. 2 has a platform section 26 with reduced thickness compared to the thickness at rim of the cavity 5. This section may be used to mount optical components for shaping and/or redirecting one or more laser beams. Alternatively, the optical components may be mounted on the thermoelectric cooler, see Fig. 4. To compare the thickness of the eyelet 2 and the wall thickness at the bottom 50, the thickness of the eyelet 2 is measured at the opening 58 of the cavity 5.

In a preferred embodiment, generally, the cavity 5 is a through hole 56 through the eyelet 2, wherein a closing element 52 is attached to the eyelet 2 and closes the cavity 5 at the second side 12. This inter alia has the advantage that the depth of the cavity 5 can be adapted by the dimensions of the closing element 52. In one refinement of this preferred embodiment, the closing element 52 is attached onto the second side 12 of the eyelet 2 an extends laterally beyond the cavity 5. The closing element 52 can have the shape of a plate. Both refinements are also realized in the example of the header 1 shown in Fig. 2. If, as shown, the plate is even with plane parallel sides, the depth of the cavity 5 equals the thickness 25 of the eyelet 2. Generally, a lateral overlap of the closing element 52 with the eyelet 2 is advantageous to dissipate heat from the thermoelectric cooler. Generally, the height of the thermoelectric cooler can be simply adapted by the shape of the closing element 52 so that different types of thermoelectric coolers can be used with a single type of eyelets 2. In one embodiment, to reduce the package height, the closing element 52 has a thickness measured at a position beside the cavity is less than half of the thickness of the eyelet 2. In the examples of Fig. 2 and Fig. 3, the thickness of the closing element 52 is uniform since the closing element 52 is plate shaped with parallel even sides. The thickness in these examples is clearly less than half of the thickness, specifically about one third of the thickness of the eyelet 2 measured at the cavity 5.

In a preferred embodiment, the closing element 52 hermetically seals the cavity 5 at the second side 12 of the header 1. This way, also a hermetic enclosure of the laser diode and other parts can be achieved in an optoelectronic package.

Generally, to fix the closing element 52 to the eyelet 2, an inorganic bond is preferred. An inorganic bond is typically less prone to long term deterioration, compared, e.g., to joints using an organic adhesive. Preferred inorganic bonds are produced by at least one of welding, soldering or brazing.

A further advantage of a through hole forming the cavity 5, or, more specifically, its side wall 57 is a simplified fabrication. Since the openings 20 of the feedthroughs are through holes as well, the one or more openings 20 for the one or more feedthroughs 22 and the through hole for the cavity 5 can be fabricated in a single step, in particular by punching. Thus, according to a further refinement, the cavity 5 and one or more openings 20 of the feedthroughs 22 are punched openings.

A particular suitable electrically conductive material for the eyelet 2 is cold rolled steel. This material is not only suitable for punching the openings for the feedthroughs and the cavity 5, but is also suitable to provide a good and hermetic bond to the insulating material 24 for the feedthroughs 22. In this regard, glass as insulating material 24 is particularly suited as it can provide a long term stable hermetic joint to a metallic eyelet 2, in particular a cold rolled steel eyelet 2. Further suitable materials for the eyelet 2 include NiFe, NiFeCo Alloys, Stainless Steel and Titanium.

The punching or stamping to produce the at least one opening 20 for the one or more feedthroughs 22 and optionally a through hole 56 for the cavity 5 may also be used to at the same time form a flange 27. This flange 27 can be used as a support and alignment for a cap to be attached and connected to the eyelet 2, thereby forming an optoelectronic package housing the laser diode in the void between the eyelet and the cap. Beside stamping or punching, other methods of forming a flange such as milling are possible. Thus, generally, without restriction to the shown example or specific fabrication methods, the eyelet 2 may advantageously comprise a flange 27 extending outward at the second side 12 of the header 1.

Generally, as also in the example of Fig. 2, a multitude of pins 23 may be arranged in a single opening 20. In other alternative or additional embodiments, one opening 20 may hold a single pin 23, forming a single electrical feedthrough, as shown in the example of Fig. 1.

Fig. 3 shows the header 1 with thermoelectric cooler 7 and laser diode 3 mounted on the thermoelectric cooler 7. As in the example of Fig. 1, the laser diode 3 is not mounted directly on the thermoelectric cooler 7 but on a submount 15 which is attached to a pedestal 14 which is mounted on and contacts the thermoelectric cooler 7, specifically, its cold plate 71. This arrangement is advantageous, inter alia, to facilitate optical alignment of the laser diode 3.

Fig. 3 is an example of an embodiment of a header 1 comprising a thermoelectric cooler 7 having a cold plate 71 and a hot plate 72, wherein the cold plate 71 and the hot plate 72 are spaced apart by intermediate Peltier elements 75, and wherein the thermoelectric cooler 7 is mounted on the bottom 50 of the cavity 5 with its hot plate 72, so that the Peltier elements 75 are arranged at least partially inside the cavity 5 and below the surface level of the first side 11 of the eyelet 2. This surface level refers to the surface adjacent to the cavity 5. As already explained above with respect to Fig. 2, there may be parts of the first side 11, such as a platform 26 having a lower surface level. However, the embodiment of the at least partially submerged Peltier elements 75 refers to the surface level at the rim of the cavity.

Preferably, the Peltier elements 75 are arranged fully below the surface level of the first side 11, or respectively, below the opening 58 of the cavity 5. This refinement is also realized in the example of Fig. 3. In other words, the Peltier elements 75 do not project from the cavity 5. In the example, the Peltier elements 75 only reach up to about half the height of the cavity 5. This embodiment can also be described as a configuration wherein the side of the cold plate 71 connected to the Peltier elements 75 is arranged below the level of the opening of the cavity 5 at the first side 11.

To facilitate electrical contacting of the Peltier elements 75, further, the thermoelectric cooler 7 may comprise one or more terminal posts 76 providing elevated electrical terminals. This way, these terminals are close to the surface level of the first side 11 and can be more easily connected to feedthroughs 22, e.g. by bond wires.

The thermoelectric cooler 7 with its capacitor-like structure of two plates, i.e., the cold plate 71 and the hot plate 72 spaced apart by the Peltier elements 75 can produce resonances at data transmission rates particularly above 10Gbit/s. This way, electromagnetic field energy is fed into the thermoelectric cooler 7, thereby considerably increasing losses. If the thermoelectric cooler 7 is submerged into the cavity so that at least a part of the Peltier elements 75 is below the surface level of the opening of the cavity 5, the thermoelectric cooler 7 is at least partly screened by the side wall 57 of the cavity 5. Of course, the screening is more effective, if the Peltier elements 75 are positioned fully below the surface level of the opening 58 of the cavity 5, as is the case in the example of Fig. 3.

In a preferred embodiment, the laser diode 3 is mounted onto the thermoelectric cooler 7 so that the laser diode 3 radiates laser light in a direction parallel to the first side 11 or second side 12 of the header 1. This embodiment is also realized in the example of Fig. 3. As can be seen, the laser beam 33 is emitted in a direction parallel to the header surface. On the platform, a lens 30 and optionally further optical elements 31 are mounted to collimate and optionally further shape or redirect the laser beam 33. The embodiment with a laser diode 3 radiating parallel to the header surface is advantageous to reduce the overall height of the optoelectronic package produced on the basis of the header 1 according to this disclosure. However, a configuration similarly as shown in the example of Fig. 1, corresponding to a conventional design, however, with a thermoelectric cooler 7 submerged into a cavity 5 is also possible. In this case, the design according to this disclosure reduces the height of the package as well. Thus, according to a further alternative or additional embodiment, the laser diode 3 is mounted onto the thermoelectric cooler 7 so that the laser diode 3 radiates laser light in a direction vertically to the first or second side 11, 12. Both embodiments can even be combined if more than one laser diode 3 is mounted on one or more thermoelectric coolers 7.

The laser diode 3 mounted onto the thermoelectric cooler 7 can be externally modulated or directly modulated. Directly modulated laser diodes are less costly. However, modulating the current through the laser diode also generally changes the charge carrier density which in turn influences the wavelength. For high speed data transmission, however, the spectral width should be as narrow as possible, and the center wavelength should be stable. Thus, in connection with a wavelength stabilizing temperature control by a thermoelectric cooler 7 as used for the header 1 according to this disclosure, it is preferred to employ an external modulated laser diode 3, in particular, to reach transmission rates of 50 Gbit/s and beyond.

The buried or submerged thermoelectric cooler 7 both reduces the package height and reduces losses of the signal strength as explained. On the other side, since the wall thickness at the bottom 50 of the cavity 5 is reduced by providing a closing element 52 being thinner than the eyelet 2, dissipation of the heat generated by the thermoelectric cooler 7 becomes more demanding. However, a good or even improved heat dissipation is possible. According to one embodiment, the closing element 52 has a higher thermal conductivity than the eyelet 2. In a further embodiment, the closing element 52 is a copper element or copper alloy element. Copper has a high thermal conductivity and is also suited for forming a hermetic joint with the eyelet 2, e.g., by brazing or soldering.

Fig. 4 shows a variant of the headers of Figs. 2, 3. This variant has a closing element 52 which is not shaped like a simple plate as in the examples of Fig. 2 and Fig. 3. Rather, the closing element 52 has a protrusion 54 extending into the through hole 55 in the eyelet 2. As in the other examples, the closing element 52 laterally extends beyond the cavity 5, in particular by a rim 53 extending about the protrusion 54. This way, the closing element 52 can be fixed to the eyelet 2 at its overlap beside the through hole 56, or, respectively, the rim 53. This way, as in the other examples, a good thermal contact and a hermetic seal can be achieved, in particular using an inorganic bond such as a brazed, welded or soldered connection. With the protrusion 54 and the rim 53 overlapping with the eyelet 2, the closing element 52 has a plug- or button-like shape.

The protrusion 54 can be used to adapt the depth of the cavity 5 to the dimensions of the thermoelectric cooler. However, as is evident from Fig. 4, the wall thickness 55 measured from the bottom 50 to the side 12 of the header 1, corresponding to the thickness of the closing element 52 within the through hole 56 is still smaller than the thickness 25 of the eyelet 2 at the cavity 5, or, respectively, at the through hole 56. The wall thickness 55 in an embodiment with a closing element 52 having a protrusion 54 and as shown in Fig. 4 is preferably given by the sum of the height 51 of the protrusion 53 and the thickness 59 of the rim 53. To maintain a cavity 5, according to this embodiment, it is expedient, generally, to use a closing element 52 having a protrusion 54 with a height 51 that is lower than the thickness 25 of the eyelet 2. However, other embodiments are possible, where this condition does not need to be met. For example, the protrusion 54 may have a varying height and may in one section even protrude above the opening 58.

As well, although in this example, the cold plate 71 of the thermoelectric cooler 7 slightly extends above the opening 58, the Peltier elements 75 are still arranged fully below the surface level of the first side 11, in particular, below the level of the opening 58. To provide a good shielding of the capacitor like structure of the thermoelectric cooler 7 against the one or more conductor traces which supply the modulation signal for the laser diode 3, it is advantageous, if the distance from the side wall 57 to the cold plate 71 is small. Preferably, the distance is smaller than about 1/10 of the wavelength of electromagnetic radiation emitted from the one or more signal conductors. This condition specifically applies to the principal frequency of the signal. For example, a digital signal with a data rate of 50GBit/S has a principal (sinodal) frequency of 25GHz. In one embodiment, therefore, the distance 73 of the cold plate 71 to the side wall 57 of the cavity 5 s smaller than 0.5 mm, preferably smaller than 0.3 mm. However, to allow for adjustment and taking into account some tolerance in the dimensions, it is further preferred to keep a distance 73 of at least 0.05 mm.

Fig. 4 is also an example of an embodiment, where at least one optical component for shaping or redirecting the laser beam 33 of the laser diode 3 is mounted on the thermoelectric cooler 7. In particular, as also in the example of Fig. 4, a lens 30 for focusing or collimating the laser beam 30 is mounted thereon. Generally, this design is beneficial as temperature induced displacements of the cold plate 71 do not influence the relative position of the laser diode 3 and the optical component, since both are mounted on the cold plate. Therefore, optical coupling efficiency will not change over temperature.

This disclosure also concerns an optoelectronic package 9 with the header 1 as described herein and a cap 35 with a window 37 for transmitting the radiation emitted from at least one laser diode 3 mounted on a thermoelectric cooler 7, the thermoelectric cooler 7 and the laser diode 3 mounted thereon being encapsulated in the volume 36 formed between the header 1 and the cap 35, the laser diode 3 and the thermoelectric cooler 7 being connected to electrical feedthroughs 22 extending through the eyelet 2. Fig. 5 shows an example of such an optoelectronic package 9 which is based on the example of Fig. 3. The cap 35 has an opening 38 which is hermetically sealed by the window 37. The cap 35 is fixed to the header 1, specifically to the eyelet 2 by a preferably hermetical, circumferential joint 36. Similar to the connection of the closing element 52 to the eyelet 2, this joint may be a braze joint, a weld joint or a solder joint. To facilitate assembly and joining, the cap 35 may have a flange 28 which is connected to flange 27 of the eyelet 2.

Following the configuration of Fig. 3, the optoelectronic package 9 is a side emitting design. However, it is also possible, to employ a header similarly to Fig. 1, however, with the thermoelectric cooler 7 placed in a cavity 5. In this case, a vertically emitting design is obtained, where the laser beam 33 exits the package 9 in a direction vertically to the sides 11, 12 of the header. As well, a vertically emitting package may be derived from a side emitting header 1 by using a deflection element to redirect the laser beam 33.

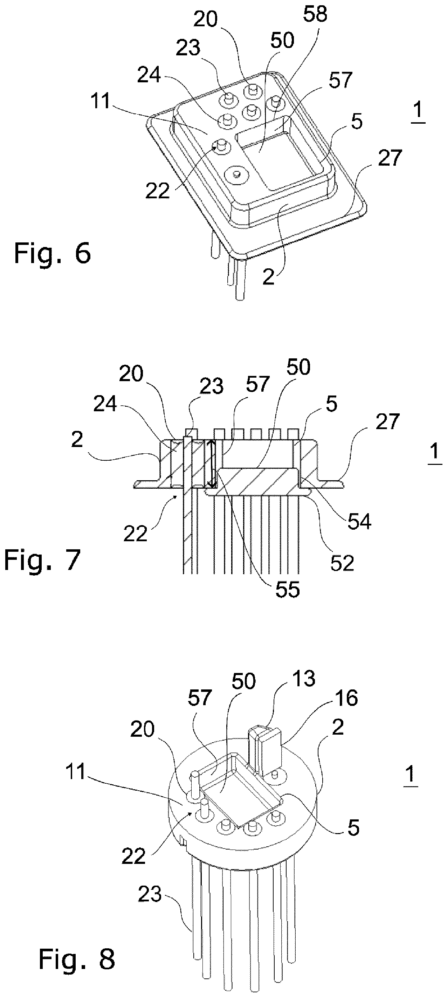

Fig. 6 and Fig. 7 shows a further example of a header 1 in perspective view and cross section. As in this example, the cavity, or its opening 58, respectively, may advantageously have a rectangular shape. More generally, the side wall 57 of the cavity 5 may have plane sections. In the example of Fig. 6, the side wall 57 has four plane sections corresponding to the four sides of the rectangular opening 58.

In a further embodiment which is also realized in the example of Figs. 6, 7, the cavity 5 has a length and a width, wherein at least one, preferably both of the length and the width have a dimension being 30 % or more of the thickness 55 of the eyelet 2. This way, a thermoelectric cooler having a large mounting surface can be accommodated.

However, the opening should not be too large to facilitate electromagnetic shielding of the submerged thermoelectric cooler 7. Thus, according to a further embodiment which as well is realized in the header 1 of Figs. 6, 7, the area of the opening 58 of the cavity 5 is smaller than the area of the first face 11 of the header 1 surrounding the opening 58. In the example of Figs. 6, 7, the area of the opening 58 is about one third of the area encompassed by the contour of side 11. To achieve good shielding, it is additionally or alternatively advantageous, if the volume of the cavity 5 is less than half of the volume of the eyelet 2.

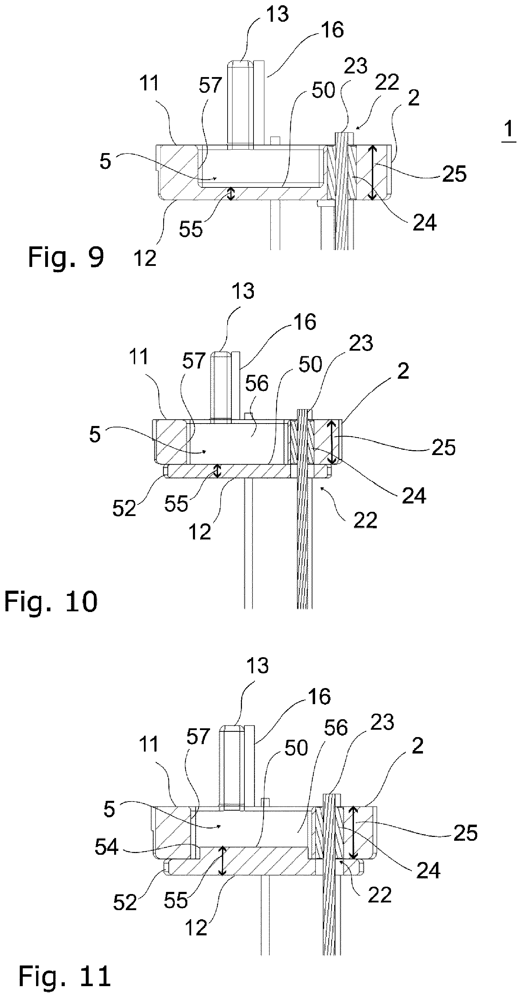

Fig. 8 shows a perspective view of a variant of the header shown in Fig. 6 and Fig. 9 is a cross-sectional view of this variant. The variant of Fig. 8 is based on a design as shown in Fig. 1, however, having a cavity 5 for accommodating a thermoelectric cooler 7 so that its Peltier elements are at least partly arranged below the surface level of first side 11. A pedestal 13 is attached onto the eyelet 2. As also similarly shown in the example of Fig. 1, a submount 16 having conductor traces for connecting to a laser diode 3 can be mounted on the pedestal 13.

A flange 27 as in the previous examples is generally optional. The example of Figs. 8, 9 does not have such a flange. Rather, a cap may be welded, brazed or soldered to the circumferential side wall of the eyelet 2.

In difference to the hitherto shown examples, it is also possible that the bottom 50 of the cavity 5 is formed from the material of the eyelet 2. This embodiment is realized in the example of Fig. 9. As can be seen, generally and without restriction to the specific example, the bottom 50, and consequently, the section of the eyelet 2 between the bottom 50 and the second side 12 are integral parts of the eyelet 2. To form a cavity 5 according to this embodiment, the eyelet 2 can be simply thinned or hollowed to reduce the thickness 25 of the eyelet 2 to the desired wall thickness 25 at the bottom 5. For example, such a cavity 5 may be formed by milling. Of course, this embodiment is not restricted to a header designed for a laser diode 3 emitting vertically to the first or second side 11, 12, side but can also be applied to an embodiment where the laser diode 3 radiates laser light in a direction parallel to the second side 12 as in the examples of Figs. 2 to 5. Vice versa, a header 1 for a vertically emitting laser diode 3 can also be produced with a closing element 52 closing a through hole 56, i.e., similarly to the examples of Figs. 2 to 5. Such variants of the design of Fig. 9 are depicted in Figs. 10 and 11.

In Fig. 10, the closing element 52 is plate shaped similarly to the example of Fig. 2. Accordingly, the wall thickness 55 between the bottom 50 of the cavity 5 and the second side 12 of the header 1 in this case corresponds to the thickness of the plate shaped closing element 52. Further, in the example of Fig. 11, the closing element 52 has a protrusion 54 extending into the through hole 56 in the eyelet 2.

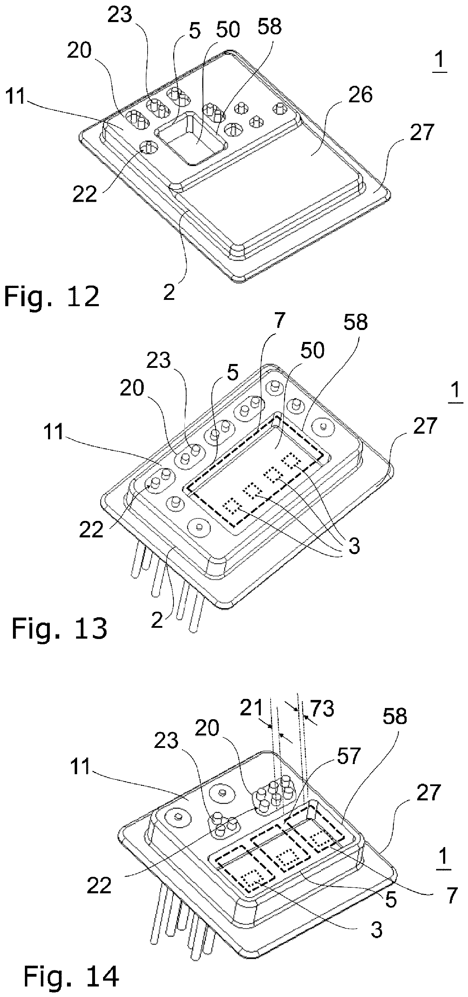

Figs. 12 to 14 show examples of headers 1 designed for multiple laser diodes 3. In the embodiment of Fig. 12, the cavity 5 is designed to accommodate a thermoelectric cooler for a single laser diode. Further laser diodes can be mounted beside the cavity if they do not need to be cooled. This is, e.g. the case if the corresponding optoelectronic package is intended to convert signals of different bandwidths. For example, the header 1 may have a laser diode for signal frequencies up to 10 Gbit/s which does not need to be cooled and a further laser diode for higher frequencies which is temperature controlled and therefore mounted on a thermoelectric cooler in the cavity 5. On the platform 26, optical components may be mounted for combining the beams of the laser diodes so that the signals can be transmitted via a single fiber. Accordingly, in one embodiment, a header 1 is provided having more than one laser diode 3, wherein at least one of the laser diodes 3 is cooled. Further, generally and without restriction to the depicted example, the header 1 may comprise at least one cooled or temperature-controlled laser diode 3 mounted on a thermoelectric cooler 7 accommodated in the cavity 5 and at least one further laser diode 3 mounted on the first side 11 beside the thermoelectric cooler 7.

In the example of Fig. 13, a comparably large cavity 5 is provided. This example is based on an embodiment, wherein at least two laser diodes 3 are mounted on a common thermoelectric cooler 7. The laser diodes 3 and the thermoelectric cooler 7 are indicated by hatched lines. The example shown is designed for a thermoelectric cooler 7 with four laser diodes 3 mounted thereon. Further, the header 1 comprises four openings 20 with two electrical feedthroughs 22 in each case. This embodiment may be particularly suited for direct modulated laser diodes 3, where both electrical supply lines are modulated.

In the similar example of Fig. 14, one opening 20 even comprises six feedthroughs 22, or six pins 23, respectively. Another opening 20 accommodated three further feedthroughs with pins 23. For example, this header 1 may be suited for three laser diodes, each mounted on an individual thermoelectric cooler 7. For example, the three laser diodes may be supplied via pairs of feedthroughs in the opening 20 with the six pins and the thermoelectric coolers 7 may be supplied via the three pins 23 in the other opening 20. Again, the thermoelectric coolers 7 and the laser diodes 3 are indicated by hatched lines. Thus, the example of Fig. 14 is generally based on an embodiment of a header 1 comprising at least two thermoelectric coolers 7, preferably arranged in a common cavity, wherein on each of the thermoelectric coolers 7 at least one laser diode 3 is mounted.

In Fig. 14, further, the distance 73 between the cold plate of the thermoelectric cooler 7 and the side wall 57 of the cavity 5 is indicated. Not only this distance 73 is relevant for leaking of the signals into the thermoelectric cooler 7. Also relevant is the distance 21 between the opening 20 of a feedthrough 22 and the side wall 57. In one embodiment, the distance 21 between the opening 20 of a feedthrough 22 next to the cavity 5 and the side wall 57 of the cavity is at least 0.1 mm, preferably at least 0.25 mm. This way, the conducting material of the eyelet 2 between the feedthrough 22 and the cavity 5 provides additional shielding against signal drain into the thermoelectric cooler 7.

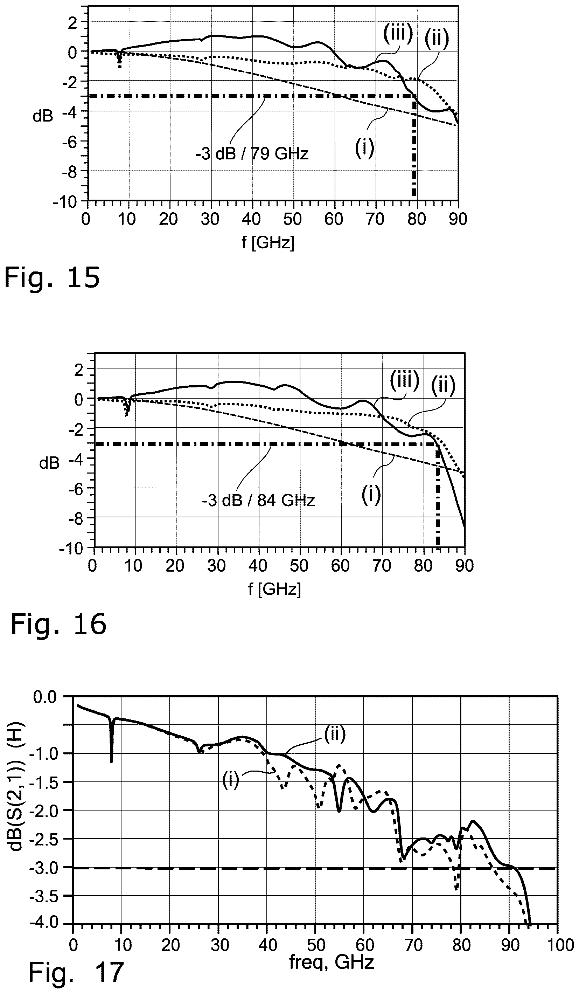

Fig. 15 shows the frequency dependence of the optoelectric response for a header with thermoelectric cooler mounted conventionally on top of the eyelet. The design of the header 1 corresponds to the example of Fig. 1. Fig. 16 shows the frequency dependence of the optoelectric response for a header according to this disclosure, i.e. with a header 1 where the thermoelectric cooler 7 is submerged in a cavity 5 in the eyelet 2. Similarly to the example of Fig. 15, the laser diode is mounted so that the laser light is radiated light in a direction vertically to the second side 12. For example, the header may have a design as shown in one of Figs. 8 to 11. In each diagram three curves (i), (ii). (iii) are shown. Curve (i) is the optoelectronic response of an externally modulated laser diode 3. Curve (ii) represents the optoelectronic response for the header without the laser diode. Finally, curve (iii) is the optoelectronic response of all combined parts, i.e. the laser diode mounted on the header 1 and connected to the conductor traces. Thus, the latter curve is particularly relevant to assess the high frequency behavior of the header 1. All curves were derived by simulation. In each diagram, the frequency where the signal is damped by 3 dB is indicated, corresponding to a loss of about 50%. As can be seen, this point shifts from 79 GHz to about 84 GHz. Thus, according to one embodiment of the header 1 or the optoelectronic package 9, the signal frequency where the loss in signal strength at the laser diode 3 exceeds 3 dB is more than 80 GHz. This embodiment is not restricted to the specific design of the header 1, in particular not restricted to the light emission direction.

In Figs. 15 and 16, two headers 1 have been compared which do not have the exact same dimensions since the header of Fig. 15 has a lower height due to the buried thermoelectric cooler 7. However, the shielding effect can also be simulated by a thermoelectric cooler 7 mounted on top of the eyelet 2 but in one case being surrounded by a shielding wall. This way, headers with and without shielding wall have the same dimensions and conductor lengths. A comparison of the optoelectronic response of two headers similarly to the example of Fig. 1, with one of the headers having a box shaped shielding wall surrounding the thermoelectric cooler 7 is shown in Fig. 17. Curve (i), shown in a hatched line is the loss for a header without shielding and curve (ii) shows the loss for the header with the box shielding the thermoelectric cooler. Clearly, as in the example of Fig. 16, the header with the shielded thermoelectric cooler provides a higher bandwidth, with the -3 dB limit at over 90 GHz. However, signal bleeding can also occur at lower frequencies. In the example of Fig. 17, curve (i) shows a resonance in the frequency range between 40 GHz and 45 GHz. This resonance can be attributed to the presence of the thermoelectric cooler 7. In the curve (ii) for the shielded thermoelectric cooler 7, this resonance is entirely eliminated. Thus, in a further embodiment, generally, the insertion loss S(2,1) is improved by at least 0.5 dB for at least one frequency in the frequency range of 0 GHz to 50 GHz compared to placement of the thermoelectric cooler 7 on a header 1 without the cavity 5. A further resonance at about 50 GHz in curve (i) is shifted to about 55 GHz. In combination, the header 1 of this example shows no pronounced resonances in a frequency range from about 36 GHz to 52 GHz. This frequency range appears to be characteristic for standard dimensioned thermoelectric coolers 7 for laser headers, as other simulations confirm. Thus, in a further embodiment, a header 1 is provided having an insertion loss course without resonantly increased insertion loss in a frequency range from 36 GHz to 52 GHz. A resonantly increased insertion loss in this regard is understood as a dip in the loss curve having a depth of at least -0.3 dB, preferably at least -0.5 dB.

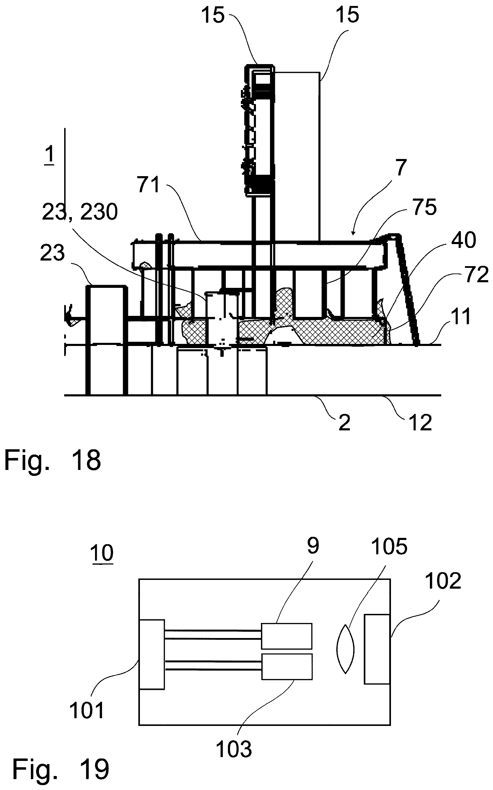

Fig. 18 demonstrates the effect of bleeding electromagnetic energy into the thermoelectric cooler 7 if the cooler is conventionally mounted on top of the eyelet 2, specifically for a configuration as shown similarly in Fig. 1. In difference to Fig. 1, this embodiment is a header for a directly modulated laser diode, with two signal conductors extending along opposite sides of the thermoelectric cooler 7. In the side view of Fig. 18, one of the signal pins 230 is visible, the other one is hidden behind the thermoelectric cooler 7. The simulation of the field strength was carried out at a signal frequency of 45 GHz. As can be seen in the image, in the proximity of the signal pun 230, areas 40 of strong field strength extend along the hot plate 72 and into the gap between the cold and hot plate 71, 72 with the Peltier elements 75. On the other side, a complementary field strength distribution can be observed with high field strength at the cold plate. The field forms a standing wave pattern, leading to strong signal bleeding. This adverse effect is strongly reduced if the thermoelectric cooler 7 is at least partly submerged into a cavity 5 in the eyelet 2.

The cavity 5 with reduced thickness also reduces the overall package size and thereby also helps designing compact and efficient electro-optical converters for bidirectional communication. An electro-optical converter 10 for high-speed data communication with transmission rates of at least 10 GBit/s which can be realized with the header 1 or, respectively, the optoelectronic package 9 according to this disclosure is schematically depicted in Fig. 19. Typically, the electro-optical converter 10 has an electrical connector 101 and an optical connector 102. The optoelectronic package 9 based on the header 1 together with an optoelectronic receiver 103 are coupled to the optical connector 102, e.g. via a lens 105 to send and receive the optical signals and are electrically coupled to the electrical connector 101 with their respective terminals, specifically, in case of the optoelectronic package 9 with the pins 23.

Although the present invention has been described with reference to preferred examples of embodiments, it is not limited thereto but can be modified in a variety of ways.

**List of reference numerals**

| | |
|---|---|
| 1 | header |
| 2 | eyelet |
| 3 | laser diode |
| 5 | cavity |
| 7 | thermoelectric cooler |
| 9 | optoelectronic package |
| 10 | electro-optical converter |
| 11 | first side of eyelet 2 |
| 12 | second side of eyelet 2 |
| 13, 14 | pedestal |
| 15, 16 | submount |
| 17 | conductor trace |
| 20 | opening |
| 21 | distance between 20, 58 |
| 22 | feedthrough |
| 23 | pin |
| 24 | insulating material |
| 25 | thickness of eyelet 2 |
| 26 | platform section on eyelet 2 |
| 27, 28 | flange |
| 30 | lens |
| 31 | optical component |
| 33 | laser beam |
| 35 | cap |
| 36 | joint between cap 35 and eyelet 2 |
| 37 | window |
| 38 | opening in cap 35 |
| 39 | volume between cap 35 and header 1 |
| 40 | high field strengh area |
| 50 | bottom of cavity 5 |
| 51 | height of protrusion 54 |
| 52 | closing element |
| 53 | rim of closing element 52 |
| 54 | protrusion of closing element 52 |
| 55 | wall thickness |
| 56 | through hole |
| 57 | side wall of cavity 5 |
| 58 | opening of cavity 5 |
| 59 | thickness of rim 53 |
| 71 | cold plate |
| 72 | hot plate |
| 73 | distance between cold plate 71 and side wall 57 of cavity 5 |
| 75 | Peltier element |
| 76 | terminal post |
| 77 | distance between cold plate 71 and side wall 57 |
| 101 | electrical connector |
| 102 | optical connector |
| 103 | optoelectronic receiver |
| 105 | lens |
| 230 | signal pin |

## Claims

1. A header (1) for an optoelectronic package, the header (1) comprising an electrically conducting eyelet (2) and at least one electrical feedthrough (22) in at least one opening (20) extending through the eyelet (2), the eyelet (2) comprising at least one cavity (5) opening to a first side (11) forming a mounting side for accommodating a thermoelectric cooler (7) with a laser diode (3) mounted thereon, so that in operation the laser diode (3) is cooled by the thermoelectric cooler (7), the cavity (5) being closed at a second side (12) opposite to the first side (11) so that a bottom (50) of the cavity (5) is formed, wherein the wall thickness (55) measured from the bottom (50) to the second side (12) opposite to the first side (11) is lower than the thickness of the eyelet (2).

2. The header (1) according to claim 1, wherein the cavity (5) is a through hole through the eyelet (2), wherein a closing element (52) is attached to the eyelet (2) and closes the cavity (5) at the second side (12).

3. The header (1) according to the preceding claim, **characterized in that** the cavity (5) and openings (20) of the feedthroughs (22) are punched openings.

4. The header (1) according to one of the two preceding claims, **characterized by** at least one of the following features:
- the closing element (52) is attached onto the second side (12) of the eyelet (2) an extends laterally beyond the cavity (5),
- the closing element is plate shaped,
- the closing element (52) has a protrusion (54) extending into the through hole (55) in the eyelet (2).

5. The header (1) according to one of the three preceding claims, **characterized by** at least one of the following features:
- the closing element (52) has a higher thermal conductivity than the eyelet (2),
- the closing element (52) hermetically seals the cavity (5) at the second side (12),
- the closing element (52) has a thickness measured at a position beside the cavity, the thickness being less than half of the thickness of the eyelet (2),
- the closing element (52) is a copper element or copper alloy element.

6. The header (1) according to one of the four preceding claims, wherein the closing element (52) is fixed to the eyelet (2) by an inorganic bond, preferably, wherein the closing element (52) is brazed, welded or soldered to the eyelet (2).

7. The header (1) according to claim 1, wherein the bottom (50) of the cavity (5) is an integral part of the eyelet (2).

8. The header (1) according to one of the preceding claims, comprising a thermoelectric cooler (7) having a cold plate (71) and a hot plate (72), the cold plate (71) and the hot plate (72) are spaced apart by intermediate Peltier elements (75), wherein the thermoelectric cooler (7) is mounted on the bottom (50) of the cavity (5) with its hot plate (72), so that the Peltier elements (75) are arranged at least partially inside the cavity and below the surface level of the first side (11) of the eyelet (2).

9. The header (1) according to the preceding claim, **characterized by** at least one of the following features:
- the Peltier elements (75) are arranged fully below the opening (58) of the cavity (5),
- the distance (73) of the cold plate (71) to the side wall (57) of the cavity (5) at least at a side of the cavity (5), is smaller than 0.5 mm, preferably smaller than 0.3 mm,
- the distance (21) between the opening (20) of a feedthrough (22) next to the cavity (5) and the side wall (57) of the cavity is at least 0.1 mm, preferably at least 0.25 mm.

10. The header (1) according to one of the two preceding claims, wherein a laser diode (3) is mounted onto the thermoelectric cooler (7) so that the laser diode (3) radiates laser light in a direction parallel or vertically to the second side (12).

11. The header (1) according to one of the preceding claims, wherein a laser diode (3) is mounted onto the thermoelectric cooler (7), wherein the laser diode (3) is externally modulated or directly modulated.

12. The header (1) according to one of the preceding claims, **characterized by** at least one of the following features:
- the cavity (5) has a rectangular shape,
- the side wall (57) of the cavity (5) has plane sections,
- the cavity (5) has a length and a width, wherein at least one, preferably both of the length and the width have a dimension being 30 % or more of the thickness (55) of the eyelet (2),
- the area of the opening (58) of the at least one cavity (5) is smaller than the area of the first face (11) of the eyelet (2) surrounding the opening (58),
- the volume of the cavity (5) is less than half of the volume of the eyelet (2),
- at least two laser diodes (3) are mounted on a common thermoelectric cooler (7).
- the header (1) comprises at least two thermoelectric coolers (7) arranged in a common cavity (5), wherein on each of the thermoelectric coolers (7) at least one laser diode (3) is mounted.

13. The header (1) according to one of the preceding claims, **characterized by** at least one of the following features:
- the signal frequency where the loss in signal strength at the laser diode (3) exceeds 3 dB is more than 80 GHz,
- the insertion loss (S(2,1)) is improved by at least 0.5 dB for at least one frequency in the frequency range of 0 GHz to 50 GHz compared to placement of the thermoelectric cooler on a header (1) without the cavity(5).,
- the header (1) has an insertion loss course without resonantly increased insertion loss in a frequency range from 36 GHz to 52 GHz.

14. An optoelectronic package (9) comprising the header (1) according to one of the preceding claims and a cap (35) with a window (37) for transmitting the radiation emitted from at least one laser diode (3) mounted on a thermoelectric cooler (7), the thermoelectric cooler (7) and the laser diode (3) mounted thereon being encapsulated in the volume (36) formed between the header (1) and the cap (35), the laser diode (3) and the thermoelectric cooler (7) being connected to electrical feedthroughs (22) extending through the eyelet (2).

15. An electro-optical converter (10) for high-speed data communication with transmission rates of at least 10 GBit/s, comprising an optoelectronic package (9) according to the preceding claim.
